# EUROPÄISCHE PATENTSCHRIFT

(11) **EP 2 037 500 B1**
(45) Veröffentlichungstag und Bekanntmachung des Hinweises auf die Patenterteilung: **09.11.2011**
(21) Anmeldenummer: 07017802.5
(22) Anmeldetag: 11.09.2007
(51) Int. Cl.: H01L 25/07

(54) **Leistungshalbleitermodul**
High performance semiconductor module
Module semi-conducteur de puissance

(43) Veröffentlichungstag der Anmeldung: 18.03.2009
(73) Patentinhaber: SIEMENS AKTIENGESELLSCHAFT, 80333 München (DE)
(72) Erfinder: Kreutzer, Rainer, 92637 Weiden (DE)

(56) Entgegenhaltungen:
- DE-A1-102006 006 421
- JP-A- 4 111 346
- US-A- 4 819 042
- US-A- 5 038 197

## Beschreibung

Die Erfindung betrifft ein Leistungshalbleitermodul mit einem Schaltungsträger und einem Gehäuse, wobei das Gehäuse zumindest zwei Kontaktbügel aufweist, bzw. ein Verfahren zur Herstellung eines solchen Leistungshalbleitermoduls.

Mit zunehmender Miniaturisierung von Halbleiterschaltelementen, insbesondere Leistungshalbleitermodulen, die einen in einem Gehäuse angeordneten Halbleiterchip umfassen, stellen die Baugröße und die höheren Kosten immer ein Problem dar. Heutzutage werden Halbleiterschaltelemente mit keramischen Schaltungsträgern mit unterschiedlichen Arten der Montage eines Schaltungsträgers (DCB: Direct Copper Bonding) in ein Gehäuse und einer Kontaktierung des Schaltungsträgers an nach außen geführten Kontaktbügel (Anschlussstift) verwendet.

Bei Lötkontakt mit auf dem keramischen Schaltungsträger bereits vormontierten Anschlussstiften erfolgt die "Nachaußenführung" der Anschlussstifte durch einfaches Zusammenstecken von Schaltungsträger und Gehäuse, dabei sich erstrecken die Anschlussstifte jeweils durch Bohrungen im Gehäuse nach außen.

In der DE 100 08 572 A1 werden in mit dem Schaltungsträger verbundene Hülsen nach dem Verbinden des Schaltungsträger mit dem Gehäuse durch Gehäuseöffnungen hindurch die Verbindungsstifte in die Hülsen eingepresst.

Bei der Aufbau- und Verbindungstechnik werden die nach außen führenden Anschlussstifte als Stanzteil ausgeführt und in das Gehäuse vormontiert (z.B. eingepresst oder eingespritzt). Der Schaltungsträger wird mit dem Gehäuse verbunden (z.B. eingeklebt). Danach wird häufig mittels eines üblichen Draht-Bondprozesses eine Verbindung zwischen dem eingepressten Anschussstift und dem Schaltungsträger hergestellt. Nähere Erläuterungen darüber sind in der DE 197 19 703 C2 bzw. in der DE 199 14 741 A1 zu finden.

Bei einem solchen Verfahren benötigt ein Bondwerkzeug zum Setzen der Verbindungspunkte einen relativ großen Verfahrfreiraum innerhalb eines Gehäuses und entsprechend große Abstände der zu verbindenden Punkte zum Gehäuse. Es kommt zu einer Folge, dass die Baugröße von Schaltelementen groß ist. Außerdem erfolgt die Verbindung der einzelnen Kontaktpunkte im Bondprozess immer nacheinander, d.h. es entstehen lange Prozesszeiten und somit höhere Kosten. Außerdem ist diese Art der Montage insbesondere bei sehr kleinen Bauelementen, wie z.B. SMD-Bauelementen, schwierig.

Die US 4 819 042 A offenbart ein Leistungshalbleitermodul mit einem Schaltungsträger und einem Gehäuse. Der Schaltungsträger weist ein Halbleiterbauelement sowie Freiflächen auf. Kontaktstifte, welche mit den Freiflächen verbunden sind, ragen hierbei durch Öffnungen des Gehäuses aus dem Gehäuse heraus.

Der Erfindung liegt die Aufgabe zugrunde, ein Leistungshalbleitermodul in einer kleinen Baugröße leicht herzustellen.

Diese Aufgabe wird erfindungsgemäß durch eine Eingabevorrichtung mit den Merkmalen des Patentanspruchs 1 und ein Verfahren mit den Merkmalen des Patentanspruchs 6 gelöst. Die abhängigen Ansprüche betreffen vorteilhafte Weiterbildungen und Ausgestaltungen der Erfindung.

Der Erfindung liegt die Erkenntnis zugrunde, den Lötvorgang für mehrere Verbindungspunkte in einem Leistungshalbleitermodul gleichzeitig auszuführen. So wird ein Leistungshalbleitermodul mit einem Schaltungsträger und einem Gehäuse aufgebaut, wobei das Gehäuse zumindest zwei nach außen führende Kontaktbügel aufweist. Der Schaltungsträger wird als eine Keramikplatte ausgestaltet und als Gehäusewand, insbesondere Gehäuseboden, in das Gehäuse eingesetzt. Auf der Seite des Schaltungsträgers, die innerhalb des Gehäuses liegt, wird mindestens ein Halbleiterbauelement elektrisch leitend angeordnet, wobei mindestens eine Freifläche, worauf kein Halbleiterbauelement bestückt ist, für den Kontakt mit einem Kontaktbügel auf der Innenseite des Schaltungsträgers frei bleibt. Vorteilhafterweise befindet sich die Freifläche des Schaltungsträgers an seinem Rand. Dadurch können die Herstel-lung von dem Leistungshalbleitermodul und eine Nacharbeitung eines nicht gut verbundenen Punktes erleichtert werden. Wenn mehrere Freiflächen vorgesehen sind, können sie natürlich auch auf dem gesamten Schaltungsträger verteilt werden. Eine elektrisch leitfähige Schicht wird als Verschaltungsebene zur elektrischen Verbindung des Halbleiterbauelementes über der Innenseite des Schaltungsträgers und dem Halbleiterbauelement angeordnet. Eine solche Schicht kann mittels Photostrukturierung und anschließender galvanischer Abscheidung von z.B. Kupfer realisiert werden. Die Kontaktbügel werden jeweils mit der elektrisch leitfähigen Schicht derart elektrisch verbunden, dass sich alle Verbindungspunkte, die durch die Verbindung der Kontaktbügel ausgebildet sind, auf der Schicht in einer parallel zu dem Schaltungsträger stehenden Ebene befinden. Durch die Anordnung der Verbindungspunkte oder Kontaktflächen in einer Ebene kann ermöglicht werden, dass alle Verbindungspunkte in einem Arbeitsgang gefertigt, also gelötet werden können. Z.B., können nun alle Verbindungen in einer einzigen Ofenfahrt (Lötvorgang) gefertigt werden. Wenn es sich bei dem Schaltungsträger um ein flächig verbundenes und verschaltetes System handelt, können solche Verbindungspunkte auch so eingestellt werden, dass alle Verbindungspunkte in einer Ebene der flächigen Verschaltungsstruktur des Systems angeordnet werden. Nebenbei kann die Herstellung aufgrund der wenigen Montage-Prozessschritte kostengünstig ermöglicht werden.

Gemäß einer vorteilhaften Ausgestaltung der Erfindung weist mindestens ein Kontaktbügel eine schlaufenförmige Ausprägung zum Ausgleich von thermomechanischen Kräften auf. Solche Kräfte entstehen, wenn das Gehäuse aus Metall oder Kunststoff besteht, während der Schaltungsträger aus Keramik besteht, weisen sie unterschiedliche Wärmeausdehnungen auf.

Gemäß einer anderen vorteilhaften Ausgestaltung der Erfindung wird mindestens ein Kontaktbügel aus elektrisch leitfähigem Kunststoff ausgebildet. Dabei wird der Kontaktbügel nicht als separates Stanzteil ausgeführt, sondern im Zweikomponentenspritzgießverfahren in Form eines leitfähigen Kunststoffs im Gehäuse mit eingespritzt. Alternativ kann der Kontaktbügel in das Gehäuse mittels Heißprägen von Kupferfolien realisiert werden.

Gemäß einer anderen vorteilhaften Ausgestaltung der Erfindung wird im Gehäuse mindestens eine nach außen weiterführenden Leiterbahn zur elektrischen Verbindung jeweils mit den Kontaktbügeln verbunden. Dabei können die korrespondierenden Leiterbahnen als separat zu montierende oder im Gehäuse eingespritzte Kontaktbügel realisiert werden. Als Alternative, können die Leiterbahnen durch Heißprägen (z.B. einer Kupferfolie) aufgebracht.

Gemäß einer anderen Ausgestaltung der Erfindung wird mindestens ein Kontaktbügel mit einer Klemme, der zumindest abschnittweise aus dem Gehäuse herausragt, mechanisch verbunden. Die Klemme wird als Anschluss zur elektrischen Verbindung mit anderen elektrischen Geräten vorgesehen.

Weiterhin wird ein Verfahren zur Herstellung eines Leistungshalbleitermoduls mit einem Schaltungsträger und einem Gehäuse angegeben, wobei zumindest zwei nach außen führende Kontaktbügel in das Gehäuse eingebaut werden, wobei der Schaltungsträger als eine Keramikplatte ausgestaltet und als eine Gehäusewand, insbesondere Gehäuseboden, eingesetzt wird. Mindestens ein Halbleiterbauelement wird auf einer innerhalb des Gehäuses liegenden Innenseite des Schaltungsträgers elektrisch leitend angeordnet, wobei mindestens eine Freifläche für den Kontakt mit einem Kontaktbügel auf der Innenseite des Schaltungsträgers vorgesehen wird, und wobei eine elektrisch leitfähige Schicht als Verschaltungsebene zur elektrischen Verbindung des Halbleiterbauelementes über der Innenseite des Schaltungsträgers und dem Halbleiterbauelement angeordnet wird. Die Kontaktbügel sind jeweils mit der Verschaltungsebene derart elektrisch verbunden, dass alle Verbindungspunkte, die durch die Verbindung der Kontaktbügel ausgebildet sind, auf der Schicht in einer parallel zu dem Schaltungsträger stehenden Ebene angeordnet sind.

Nachfolgend wird die Erfindung anhand der in den Figuren dargestellten Ausführungsbeispiele näher beschrieben und erläutert. Es zeigen:
- FIG 1: Ein Beispiel eines erfindungsgemäßen Leistungshalb- leitermoduls,
- FIG 2: ein mittels Heißprägen von Kupperfolien ausgebilde- ter Kontaktbügel,
- FIG 3: ein erfindungsgemäßes Leistungshalbleitermodul auf Basis von SMD-Technik.

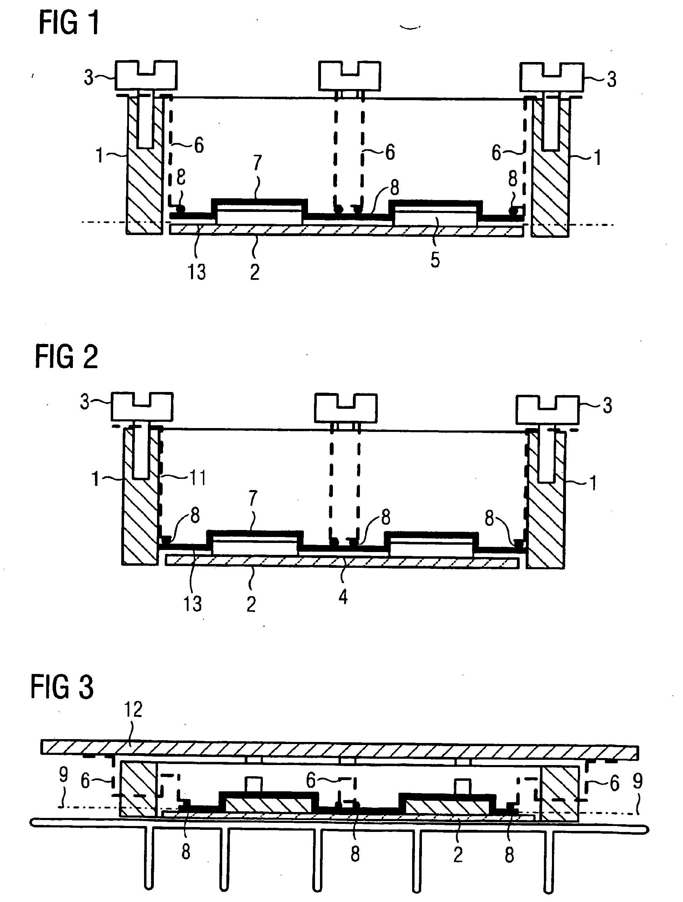

In der FIG 1 wird ein Leistungshalbleitermodul gezeigt. Das Leistungshalbleitermodul weist einen Schaltungsträger 2 und ein Gehäuse 1 auf, wobei der Schaltungsträger 2 eine Keramikplatte ist und als Gehäuseboden in das Gehäuse 1 eingesetzt wird, und wobei das Gehäuse 1 drei nach außen führende Kontaktbügel 6 aufweist. Die Kontaktbügel 6 sind im Gehäuse 1 vormontiert, vorzugsweise eingespritzt. Im Gehäuse 1 werden dabei korrespondierende nach außen weiterführende Leiterbahnen 11 als separat zu montierende oder im Gehäuse 1 eingespritzte Kontaktbügel 6 realisiert. Die Leiterbahnen 11 nehmen jeweils mit den Kontaktbügeln 6 zur elektrischen Verbindung einen Kontakt. Auf der Innenseite 13 des Schaltungsträgers 2 innerhalb des Gehäuses 1 werden mehrere Halbleiterbauelemente 5 (z.B. Halbleiterchips) dadurch elektrisch leitend angeordnet, dass eine elektrisch leitfähige Schicht 7 (z.B. Kupferstruktur) als Verschaltungsebene über der Innenseite 13 des Schaltungsträgers 2 und dem Halbleiterbauelement 5 angeordnet wird. Dabei ist eine Freifläche 4, worauf sich kein Halbleiterbauelement 5 befindet, für den Kontakt mit einem Kontaktbügel 6 auf der Innenseite 13 des Schaltungsträgers 2 vorhanden. Bei der Montage des Schaltungsträgers 2 ins Gehäuse 1 kommen die Kontaktflächen der Kontaktbügel 6 genau deckungsgleich auf den zu verbindenden Freiflächen 4 des Schaltungsträgers 2 zum liegen. Die drei Kontaktbügel 6 werden jeweils mit der elektrisch leitfähigen Schicht 7 derart elektrisch so verbunden, dass alle Verbindungspunkte 8, die durch die Verbindung der Kontaktbügel 6 und der Schicht 7 entstanden sind, auf der Schicht 7 in einer parallel zu dem Schaltungsträger 2 stehenden Ebene angeordnet sind. Außerdem wird jeder Kontaktbügel 6 mit einer Klemme 3, die abschnittweise aus dem Gehäuse 1 herausragt, mechanisch verbunden. Durch die Klemmen 3 kann das Leistungshalbleitermodul mit anderen elektrischen Geräten weiter elektrisch verbunden werden.

Dadurch, dass alle Verbindungspunkte 8 in einer Ebene angeordnet werden, ist es möglich, dass alle Verbindungspunkte in einem Arbeitsgang, z.B. Ofenfahrt, fertig gelötet werden können. Dies ermöglicht eine erheblich kürze Montagezeit und wenige Montageschritte, somit können solche Leistungshalbleitermodule kostengünstig hergestellt werden. Da in dem Herstellungsverfahren kein zusätzliches Bondwerkzeug zum Setzen der Verbindungspunkte 8 benötigt wird, ist ein großer Freiraum innerhalb eines Gehäuses 1 und ein großer Abstand zwischen den Verbindungspunkten 8 und dem Gehäusewand nicht notwendig.

FIG.2 zeigt ein Leistungshalbleitermodul, wobei zwei Kontaktbügel 6 jeweils an der Gehäusewand des Leitungshalbleitermoduls eingebaut sind. Die zu der Verbindungspunkten 8 korrespondierenden nach außen am Gehäuse 1 weiterführenden Leiterbahnen 11 werden durch Heißprägen (z.B. einer Kupferfolie) oder ein anderes auf Kunststoffoberflächen Leiterbahnen strukturierendes Verfahren (MID-Technologie) aufgebracht. Mit dem Schaltungsträger 2 wird anschließend ein elektrischer Kontakt herstellt. Alle Verbindungspunkte einschließlich des Verbindungspunktes, der durch den mittleren, nicht an der Gehäusewand liegenden Kontaktbügel 6 ausgebildet ist, sollten sich in einer parallel zu dem Schaltungsträger 2 stehenden Ebene befinden.

In FIG 3 handelt es sich der Gesamtanordnung um ein SchaltElement mit Eignung für SMD-Oberflächenlötung auf eine Platine 12. Hier sind die Kontaktbügel 6 so ausgestaltet, dass sie vorab auf einer Platine 12 angeordnet werden können. Dabei können die Verbindungspunkte 8, der Kontaktbügel 6 und die elektrisch leitende Schicht 7 in einer Ebene 9 der flächigen Verschaltungsstruktur des Systems eingestellt werden.

## Patentansprüche

1. Leistungshalbleitermodul mit einem Schaltungsträger (2) und einem Gehäuse (1),
wobei das Gehäuse (1) zumindest zwei nach außen führende Kontaktbügel (6) aufweist,
wobei der Schaltungsträger (2) als eine Keramikplatte ausgestaltet als Gehäusewand, insbesondere Gehäuseboden, eingesetzt ist,
wobei mindestens ein Halbleiterbauelement (5) auf einer Innenseite (13) des Schaltungsträgers (2) elektrisch leitend angeordnet ist,
wobei mindestens eine Freifläche (4) auf der Innenseite des Schaltungsträgers (2) vorhanden ist und
wobei eine elektrisch leitfähige Schicht (7) als Verschaltungsebene zur elektrischen Verbindung des Halbleiterbauelementes (5) über der Innenseite (13) des Schaltungsträgers (2) und dem Halbleiterbauelement (5) angeordnet ist,
wobei die Kontaktbügel (6) jeweils mit der elektrisch leitfähigen Schicht (7) derart elektrisch verbunden sind, dass sich alle Verbindungspunkte (8), die durch die Verbindung der Kontaktbügel (6) mit der Schicht (7) ausgebildet sind, auf der Schicht (7) in einer parallel zu dem Schaltungsträger (2) stehenden Ebene befinden, **dadurch gekennzeichnet, dass** die Kontaktbügel (6) im Zweikomponentenspritzgießverfahren in Form eines elektrisch leitfähigen Kunststoffes im Gehäuse (1) mit eingespritzt sind oder durch am Gehäuse (1) mittels Heissprägen aufgebrachte Leiterbahnen (11) ausgebildet sind.

2. Leistungshalbleitermodul nach Anspruch 1, wobei mindestens ein Kontaktbügel (6) eine schlaufenförmige Ausprägung zum Ausgleich von thermomechanischen Kräften aufgrund unterschiedlicher Ausdehnung von dem Gehäuse (1) und dem Schaltungsträger (2) aufweist.

3. Leistungshalbleitermodul nach Anspruch 1 oder 2, wobei mindestens ein Kontaktbügel (6) ein elektrisch leitfähiger Kunststoff ist.

4. Leistungshalbleitermodul nach einem der vorstehenden Ansprüche, wobei
im Gehäuse (1) mindestens eine nach außen weiterführenden Leiterbahn (11) zur elektrischen Verbindung mit einem Kontaktbügel (6) verbindbar ist.

5. Leistungshalbleitermodul nach einem der vorstehenden Ansprüche, wobei
mindestens ein Kontaktbügel (6) mit einer Klemme (3), der zumindest abschnittweise aus dem Gehäuse (1) herausragt, mechanisch verbunden ist, wobei die Klemme (3) als Anschluss zur elektrischen Verbindung mit anderen elektrischen Geräten vorgesehen ist.

6. Verfahren zur Herstellung eines Leistungshalbleitermoduls mit einem Schaltungsträger (2) und einem Gehäuse (1),
wobei zumindest zwei nach außen führende Kontaktbügel (6) in das Gehäuse (1) vormontiert werden,
wobei der Schaltungsträger (2) als eine Keramikplatte ausgestaltet und als eine Gehäusewand, insbesondere Gehäuseboden, eingesetzt wird,
wobei mindestens ein Halbleiterbauelement (5) auf einer Innenseite (13) des Schaltungsträgers (2) elektrisch leitend angeordnet wird,
wobei mindestens eine Freifläche (4) auf der Innenseite (13) des Schaltungsträgers (2) vorgesehen wird und
wobei eine elektrisch leitfähige Schicht (7) als Verschaltungsebene zur elektrischen Verbindung des Halbleiterbauelementes (5) über der Innenseite des Schaltungsträgers (2) und dem Halbleiterbauelement (5) angeordnet wird,
wobei die Kontaktbügel (6) jeweils mit der Verschaltungsebene (7) derart elektrisch so verbunden werden, dass alle Verbindungspunkte (8), die durch die Verbindung der Kontaktbügel (6) ausgebildet sind, auf der Schicht (7) in einer parallel zu dem Schaltungsträger (2) stehenden Ebene angeordnet sind,
wobei mindestens ein Kontaktbügel (6) im Zweikomponentenspritzgiessverfahren in Form eines elektrisch leitfähigen Kunststoffes im Gehäuse (1) mit eingespritzt ist oder die Kontaktbügel (6) durch am Gehäuse mittels Heissprägen (1) aufgebrachte Leiterbahnen (11) ausgebildet werden.

7. Verfahren nach Anspruch 6, wobei
eine schlaufenförmige Ausprägung mindestens bei einem Kontaktbügel (6) zum Ausgleich von thermomechanischen Kräften aufgrund unterschiedlicher Ausdehnung von dem Gehäuse (1) und dem Schaltungsträger (2) vorgesehen wird.

8. Verfahren nach einem der Ansprüche 6 bis 7, wobei im Gehäuse (1) mindestens eine nach außen weiterführenden Leiterbahn (11) zur elektrischen Verbindung mit einem Kontaktbügeln (6) verbunden wird.

9. Verfahren nach einem der Ansprüche 6 bis 8, wobei mindestens ein Kontaktbügel (6) mit einer Klemme (3), der zumindest abschnittweise aus dem Gehäuse (1) herausragt, mechanisch verbunden wird, wobei die Klemme (3) als Anschluss zur elektrischen Verbindung mit anderen elektrischen Geräten vorgesehen wird.

10. Verfahren nach einem der Ansprüche 6 bis 9, wobei sich die Freiflächen (4) des Schaltungsträgers (2) an seinem Rand befinden.

11. Verfahren nach einem der Ansprüche 6 bis 10, wobei die Kontaktbügel (6) jeweils mit den Freiflächen (4) der Verschaltungsebene (7) verbunden werden.

12. Verfahren nach einem der Ansprüche 6 bis 11, wobei alle Verbindungspunkte (8), die durch die Verbindung der Kontaktbügel (6) ausgebildet sind, auf der Schicht (7) in einer parallel zu dem Schaltungsträger (2) stehenden Ebene angeordnet sind.

13. Leistungshalbleitermodul nach Anspruch 1 bis 5, wobei die Kontaktbügel (6) jeweils mit den Freiflächen (4) der Verschaltungsebene (7), welche sich vorzugsweise am Rand des Schaltungsträgers (2) befinden, verbunden sind.

## Claims

1. Power semiconductor module comprising a circuit carrier (2) and a housing (1),
wherein the housing (1) has at least two contact clips (6) leading towards the outside,
wherein the circuit carrier (2) configured as a ceramic plate is used as a housing wall, in particular a housing base, wherein at least one semiconductor component (5) is arranged in an electrically conductive manner on an inner side (13) of the circuit carrier (2),
wherein at least one free area (4) is present on the inner side of the circuit carrier (2), and
wherein an electrically conductive layer (7) is arranged as an interconnection plane for electrically connecting the semiconductor component (5) above the inner side (13) of the circuit carrier (2) and the semiconductor component (5), wherein the contact clips (6) are in each case electrically connected to the electrically conductive layer (7) in such a way that all the connection points (8) which are formed by the connection of the contact clips (6) to the layer (7) are situated on the layer (7) in a plane located parallel to the circuit carrier (2), **characterized in that** the contact clips (6) are concomitantly injected in the form of an electrically conductively plastic in the housing (1) in the two-component injection-moulding method or are formed by conductor tracks applied to the housing (1) by means of hot embossing.

2. Power semiconductor module according to Claim 1, wherein at least one contact clip (6) has a looped embodiment for compensating for thermomechanical forces on account of different expansion of the housing (1) and the circuit carrier (2).

3. Power semiconductor module according to Claim 1 or 2, wherein
at least one contact clip (6) is an electrically conductive plastic.

4. Power semiconductor module according to any of the preceding claims, wherein
in the housing (1) at least one conductor track (11) which continues towards the outside can be connected for electrical connection to a contact clip (6).

5. Power semiconductor module according to any of the preceding claims, wherein
at least one contact clip (6) is mechanically connected to a terminal (3) projecting at least in sections from the housing (1) wherein the terminal (3) is provided as a connection for electrical connection to other electrical devices.

6. Method for producing a power semiconductor module comprising a circuit carrier (2) and a housing (1),
wherein at least two contact clips (6) leading towards the outside are premounted into the housing (1),
wherein the circuit carrier (2) is configured as a ceramic plate and is used as a housing wall, in particular a housing base,
wherein at least one semiconductor component (5) is arranged in an electrically conductive manner on an inner side (13) of the circuit carrier (2),
wherein at least one free area (4) is provided on the inner side (13) of the circuit carrier (2), and
wherein an electrically conductive layer (7) is arranged as an interconnection plane for electrically connecting the semiconductor component (5) above the inner side of the circuit carrier (2) and the semiconductor component (5),
wherein the contact clips (6) are in each case electrically connected to the interconnection plane (7) in such a way that all the connection points (8) which are formed by the connection of the contact clips (6) are arranged on the layer (7) in a plane located parallel to the circuit carrier (2), wherein at least one contact clip (6) is concomitantly injected in the form of an electrically conductive plastic in the housing (1) in the two-component injection-moulding method or the contact clips (6) are formed by conductor tracks (11) applied to the housing (1) by means of hot embossing.

7. Method according to Claim 6, wherein
a looped embodiment is provided at least in the case of one contact clip (6) for compensating for thermomechanical forces on account of different expansion of the housing (1) and the circuit carrier (2).

8. Method according to either of Claims 6 and 7, wherein
in the housing (1) at least one conductor track (11) which continues towards the outside is connected for electrical connection to a contact clip (6).

9. Method according to any of Claims 6 to 8, wherein
at least one contact clip (6) is mechanically connected to a terminal (3) projecting at least in sections from the housing (1) wherein the terminal (3) is provided as a connection for electrical connection to other electrical devices.

10. Method according to any of Claims 6 to 9, wherein the free areas (4) of the circuit carrier (2) are situated at the edge thereof.

11. Method according to any of Claims 6 to 10, wherein the contact clips (6) are respectively connected to the free areas (4) of the interconnection plane (7).

12. Method according to any of Claims 6 to 11, wherein all the connection points (8) which are formed by the connection of the contact clips (6) are arranged on the layer (7) in a plane located parallel to the circuit carrier (2).

13. Power semiconductor module according to Claims 1 to 5, wherein the contact clips (6) are respectively connected to the free areas (4) of the interconnection plane (7) which are preferably situated at the edge of the circuit carrier (2).

## Revendications

1. Module de semi-conducteur de puissance comprenant un porte--circuit ( 2 ) et un boîtier ( 1 ),
dans lequel le boîtier ( 1 ) a au moins deux étriers ( 6 ) de courant menant à l'extérieur,
dans lequel le porte-circuit ( 2 ) conformé en plaque de céramique est utilisé comme paroi du boîtier, notamment comme fond du boîtier,
dans lequel au moins un composant ( 5 ) à semi-conducteur est monté d'une manière conductrice de l'électricité sur une face ( 13 ) intérieure du porte-circuit ( 2 ),
dans lequel il y a au moins une surface ( 4 ) dégagée sur la face intérieure du porte-circuit ( 2 ) et
dans lequel une couche ( 7 ) conductrice de l'électricité est disposée, en tant que plan de câblage pour la liaison électrique du composant ( 5 ) à semi-conducteur, sur la face ( 13 ) intérieure du porte-circuit ( 2 ) et sur le composant ( 5 ) à semi-conducteur,
dans lequel les étriers ( 6 ) de courant sont reliés électriquement respectivement à la couche ( 7 ) conductrice de l'électricité de manière à ce que tous les points ( 8 ) de liaison qui sont formés par la liaison des étriers ( 6 ) de courant avec la couche ( 7 ) se trouvent sur la couche ( 7 ) dans un plan s'étendant parallèlement au porte-circuit ( 2 ), **caractérisé en ce que** les étriers ( 6 ) de courant sont fabriqués par injection avec le boîtier ( 1 ) sous la forme d'une matière plastique conductrice de l'électricité suivant un procédé de moulage par injection à deux composants ou sont formés par des pistes ( 11 ) conductrices déposées sur le boîtier ( 1 ) au moyen d'un estampage à chaud.

2. Module de semi-conducteur de puissance suivant la revendication 1, dans lequel au moins un étrier ( 6 ) de courant a un estampage en forme de boucle pour la compensation de forces thermomécaniques dues à la différence de dilatation entre le boîtier ( 1 ) et le porte-circuit ( 2 ).

3. Module de semi-conducteur de puissance suivant la revendication 1 ou 2, dans lequel au moins un étrier ( 6 ) de courant est une matière plastique conductrice de l'électricité.

4. Module de semi-conducteur de puissance suivant l'une des revendications précédentes, dans lequel
dans le boîtier ( 1 ) au moins une piste ( 11 ) conductrice menant à l'extérieur peut être reliée à un étrier ( 6 ) de courant pour la liaison électrique.

5. Module de semi-conducteur de puissance suivant l'une des revendications précédentes, dans lequel
au moins un étrier ( 6 ) de courant est relié mécaniquement à une cosse ( 3 ) qui dépasse au moins par endroit du boîtier ( 1 ), la cosse ( 3 ) étant prévue comme borne pour la liaison électrique avec d'autres appareils électriques.

6. Procédé de fabrication d'un module à semi-conducteur de puissance ayant un porte-circuit ( 2 ) et un boîtier ( 1 ), dans lequel on monte à l'avance dans le boîtier ( 1 ) au moins deux étriers ( 6 ) de courant menant à l'extérieur,
dans lequel on conforme le porte-circuit ( 2 ) sous la forme d'une plaque en céramique et on l'utilise en tant que paroi du boîtier notamment en tant que fond du boîtier,
dans lequel on met d'une manière conductrice de l'électricité au moins un composant ( 5 ) à semi-conducteur sur une face ( 3 ) intérieure du porte-circuit ( 2 ),
dans lequel on prévoit au moins une surface ( 4 ) dégagée sur la face ( 13 ) intérieure du porte-circuit ( 2 ) et,
dans lequel on met une couche ( 7 ) conductrice de l'électricité, comme plan de câblage pour la liaison électrique du composant ( 5 ) à semi-conducteur, sur la face intérieure du porte-circuit ( 2 ) et sur le composant ( 5 ) à semi-conducteur,
dans lequel on relie électriquement les étriers ( 6 ) de courant respectivement au plan ( 7 ) de câblage de manière à ce que tous les points ( 8 ) de liaison qui sont formés par la liaison des étriers ( 6 ) de courant soient sur la couche ( 7 ) dans un plan s'étendant parallèlement au porte-circuit ( 2 ),
dans lequel on injecte au moins un étrier ( 6 ) de courant suivant un procédé de moulage par injection à deux composants sous la forme d'une matière plastique conductrice d'électricité dans le boîtier ( 1 ) ou on forme les étriers ( 6 ) de courant par des pistes ( 11 ) conductrices déposées sur le boîtier ( 1 ) au moyen d'un estampage à chaud.

7. Procédé suivant la revendication 6, dans lequel on prévoit un estampage en forme de boucle au moins pour un étrier ( 6 ) de courant pour la compensation de forces thermomécaniques dues à des différences de dilatation entre le boîtier ( 1 ) et le porte-circuit ( 2 ).

8. Procédé suivant l'une des revendications 6 à 7, dans lequel dans le boîtier on relie pour la liaison électrique au moins une piste ( 11 ) conductrice menant à l'extérieur à un étrier ( 6 ) de courant.

9. Procédé suivant l'une des revendications 6 à 8, dans lequel on relie mécaniquement au moins un étrier ( 6 ) de courant à une cosse ( 3 ) qui dépasse au moins par endroit du boîtier ( 1 ), la cosse ( 3 ) étant prévue comme borne pour la liaison électrique avec d'autres appareils électriques.

10. Procédé suivant l'une des revendications 6 à 9, dans lequel
les surfaces ( 4 ) dégagées du porte-circuit ( 2 ) se trouvent sur son bord.

11. Procédé suivant l'une des revendications 6 à 10, dans lequel
on relie les étriers ( 6 ) de courant respectivement aux surfaces ( 4 ) dégagées du plan ( 7 ) de câblage.

12. Procédé suivant l'une des revendications 6 à 11, dans lequel
on met tous les points ( 8 ) de liaison, qui sont formés par la liaison des étriers ( 6 ) de courant, sur la couche ( 7 ) dans un plan s'étendant parallèlement au porte-circuit ( 2 ).

13. Module de semi-conducteur de puissance suivant la revendication 1 à 5, dans lequel
les étriers ( 6 ) de courant sont reliés respectivement aux surfaces ( 4 ) dégagées du plan ( 7 ) de câblage, lesquelles se trouvent de préférence au bord du porte-circuit ( 2 ).
